# EUROPÄISCHE PATENTSCHRIFT

(11) **EP 4 125 215 B1**
(45) Veröffentlichungstag und Bekanntmachung des Hinweises auf die Patenterteilung: **09.04.2025**
(21) Anmeldenummer: 21187834.3
(22) Anmeldetag: 27.07.2021
(51) Int. Cl.: H03K 17/95

(54) **ELEKTRISCHER SCHALTKREIS, INSBESONDERE FÜR EINEN INDUKTIV BETRIEBENEN NÄHERUNGSSCHALTER**
ELECTRICAL CIRCUIT, IN PARTICULAR FOR AN INDUCTIVELY OPERATED PROXIMITY SWITCH
CIRCUIT ÉLECTRIQUE, EN PARTICULIER POUR UN INTERRUPTEUR DE PROXIMITÉ À COMMANDE INDUCTIVE

(43) Veröffentlichungstag der Anmeldung: 01.02.2023
(73) Patentinhaber: wenglor sensoric elektronische Geräte GmbH, 88069 Tettnang (DE)
(72) Erfinder: Kreutle, Johannes, 88255 Baindt (DE); Karadimos, Christoph, 88214 Ravensburg (DE); Träger, Heiko, 88079 Kressbronn (DE); Dräger, Andreas, 88074 Meckenbeuren (DE); Pahari, Sijan, 88045 Friedrichshafen (DE)
(74) Vertreter: Christ, Niko

(56) Entgegenhaltungen:
- DE-A1- 102009 044 820
- DE-A1- 4 427 990
- DE-C1- 4 427 283
- US-A1- 2009 021 248

## Beschreibung

Die Erfindung bezieht sich auf einen elektrischen Schaltkreis, durch den ein induktiv betriebener Näherungsschalter gebildet ist, nach dem Oberbegriff des Patentanspruches 1.

Ein solcher Näherungsschalter ist bereits aus der US 2009/0021248 A1 vorbekannt. Dieser betrifft einen gegenüber Umwelteinflüssen wie Temperatur und Feuchtigkeit verbesserten Näherungsschalter, bei dem bei der Abstandsmessung die Frequenz einer Sendespule bei offenem und geschlossenem Stromkreis erfasst und die Ergebnisse miteinander verglichen werden, wobei das Ergebnis zur Festlegung eines Schaltpunkts genutzt wird.

Derartige Näherungsschalter sind allgemein seit langem bekannt und weisen verschiedene Schaltaufbauten und damit verbundene unterschiedliche Funktionsweisen auf. Beispielsweise kann der DE 103 45 819 B4 ein Näherungsschalter mit einem LC-Schwingkreises und mit einer Oszillatorschaltung zur Anregung der Schwingung in dem Schwingkreis entnommen werden. Durch eine der Oszillatorschaltung nachgeschaltete Auswerteeinheit wird das Schwingverhalten, insbesondere die Schwingungsamplitude des Schwingkreises überwacht. Bei einer Annäherung eines metallischen Objektes in den dreidimensionalen Überwachungsbereich ist dem Schwingkreis Energie entzogen und die Amplitude sinkt, sodass der Näherungsschalter bzw. die Auswerteeinheit ein entsprechendes Schaltsignal generiert.

Darüber hinaus ist zwischen dem Schwingkreis und der Auswerteeinheit ein sogenannter Umschalter vorgesehen, der in eine geschlossene und eine geöffnete Position geschaltet ist, um eine redundante Auswertung sicherzustellen.

Es hat sich jedoch bei einem solchen Funktionsprinzip eines Näherungsschalters als nachteilig ergeben, dass das Auswerteverfahren nicht zuverlässig gewährleistet, dass ein Fehler im Schwingkreis erkannt ist, wenn beispielsweise das eine oder andere elektrische Bauteil kaputt ist oder dessen zugeordnete Funktionsweise nicht länger gegeben ist.

Darüber hinaus ist nachteilig, dass ein solcher Näherungsschalter auf unterschiedliche Metalle der in den Überwachungsbereich eintauchenden Objekte einen unterschiedlichen Schaltabstand aufweist. Beispielsweise bei Objekten aus dem Werkstoff Aluminium oder aus Buntmetallen, wie zum Beispiel Kupfer, beträgt der Schaltabstand ein Drittel des Schaltabstandes eines Objektes aus einem StahlWerkstoff. Folglich ist die Anwendungsbreite solcher Näherungsschalter erheblich eingeschränkt.

Ein dazu andersartiges Verfahren kann beispielsweise der DE 10 2014 016 217 A1 entnommen werden. Dort erfolgt die Messung des Schaltabstandes mit einem LC-Schwingkreis und einer dazu parallel geschalteten Oszillatorschaltung. Bei dem dort beschriebenen Näherungsschalter wertet jedoch die vorhandene Auswerteeinheit die Frequenzänderungen aus, die bei einem sich annähernden metallischen Objekt innerhalb des Überwachungsbereichs in dem Schwingkreis eine Frequenzänderung erzeugt.

Solche Näherungsschalter können zwar für unterschiedliche metallische Werkstoffe verwendet sein, denn der Schaltabstand verändert sich aufgrund der unterschiedlichen Materialeigenschaften nicht, jedoch ist bei solchen Näherungsschaltern nachteiligerweise nicht sichergestellt, dass kaputte oder fehlerhafte elektrische Komponenten des Näherungsschalters, die dessen Funktion stören, zuverlässig erkannt sind. Insbesondere bei sicherheitsrelevanten Anwendungen solcher Näherungsschalter ist es jedoch zwingend geboten, den Näherungsschalter und dessen Bauteile permanent oder zumindest zeitweise dahingehend zu überprüfen, ob der Näherungsschalter zuverlässig funktioniert, also dass dessen elektrischen Komponenten ordnungsgemäß arbeiten.

Es ist daher Aufgabe der Erfindung, einen Näherungsschalter der eingangs genannten Gattung derart weiterzubilden, dass dieser sowohl für sämtliche Arten von metallischen Werkstoffen einsetzbar ist, ohne dass sich der Schaltabstand des Näherungsschalters aufgrund der unterschiedlichen Werkstoffeigenschaften gravierend verändert, und dass zum anderen die den Näherungsschalter bildenden elektrischen Komponenten permanent oder zumindest zeitweise zuverlässig dahingehend überwacht bzw. überprüft sind, ob diese funktionieren und folglich eine sichere Schaltabstandsmessung erfolgen kann.

Diese Aufgabe ist erfindungsgemäß durch die Merkmale des kennzeichnenden Teils von Patentanspruch 1 gelöst.

Weitere vorteilhafte Weiterbildungen der Erfindung ergeben sich aus den Unteransprüchen.

Dadurch, dass dem Schwingkreis eine Referenzspule zugeordnet ist, die zu der Sendespule und dem Oszillator parallel geschaltet ist, dass der Oszillator an einem Logik-Kanal angeschlossen ist, dass zwischen der Referenzspule und der Masse mindestens ein Schalter vorgesehen ist, der von der Auswerteeinheit und/oder dem Logik-Kanal geschlossen oder geöffnet ist, und dass in dem Logikkanal der Referenzspule Datensätze hinterlegt und/oder einprogrammierbar sind, durch die die Funktionsweise des Schwingkreises anhand von vorgegebenen Frequenzen und/oder Amplituden überprüfbar sind, ist gewährleistet, dass die den Näherungsschalter bildenden elektrischen Komponenten permanent oder zumindest in einem vorgegebenen Zeitzyklus überprüft sind, ob diese zuverlässig funktionieren und zum anderen kann aufgrund der Frequenzänderung beim Eintritt eines metallischen Objektes in den Überwachungsbereich ein Schaltsignal generiert sein, das von der Werkstoffeigenschaft des jeweiligen Objektes unabhängig ist.

Aufgrund der elektrotechnischen Anordnung von zwei Schaltern und deren jeweiliger Zuordnung zu der Sendespule bzw. der Referenzspule ist eine abwechselnde Ansteuerung der Sendespule und der Referenzspule ermöglicht. Die Sendespule misst dabei den Schaltabstand zwischen dieser und einem in den Überwachungsbereich eingetauchten metallischen Objekt, wodurch ein Allmetall-Näherungsschalter zur Verfügung gestellt ist und durch das wechselseitige Anschalten der Referenzspule und gleichzeitiges Abschalten der Sendespule können die in dem Schwingkreis vorhandenen elektrischen Bauteile auf deren Funktionsfähigkeit zeitsparend und zuverlässig überprüft werden. Die Ansteuerung der Sendespule ist dabei als Schaltphase für den üblichen Betrieb des Näherungsschalters anzusehen; wohingegen die Ansteuerung der Referenzspule als Überprüfungsphase zur Beurteilung, ob die in dem Näherungsschalter verbauten elektrischen Bauteile tatsächlich funktionsfähig sind. Eine solche permanente Überprüfung dient dazu, den Näherungsschalter zuverlässig in einer sicherheitsrelevanten Anwendung betreiben zu können, denn sobald durch die Zuschaltung der Referenzspule festgestellt ist, dass die verwendeten Bauteile funktionsgestört sind oder deren Zusammenwirken gestört ist, schaltet der Näherungsschalter in den sicheren Schaltzustand.

Sowohl in der Auswerteeinheit als auch in dem Logikkanal können dabei Datensätze hinterlegt oder einprogrammiert sein, die zur Überprüfung der verwendeten elektrischen Bauteile herangezogen werden können. Sobald nämlich die Referenzspule zugeschaltet ist, schwingt der Schwingkreis in einem vorgegebenen Phasenablauf, der mit den hinterlegten Datensätzen verglichen werden kann. Bei entsprechenden Abweichungen bzw. Über- oder Unterschreiten von vorgegebenen Grenzwerten schaltet der Näherungsschalter automatisch in den sicheren Schaltzustand, denn es ist zu überprüfen, inwieweit die verwendeten elektrotechnischen Bauteile funktionsgerecht sind.

In der Zeichnung ist ein Ausführungsbeispiel eines Näherungsschalters dargestellt, der nachfolgend näher erläutert ist. Im Einzelnen zeigt:
- Figur 1a: einen elektrischen Schaltkreis, durch den ein induktiv betriebener Näherungsschalter gebildet ist mit einer einem Überwachungsbereich zugewandten Sendespule und einer dazu parallel geschalteten Referenzspule sowie einem Oszillator- und einem LC-Schaltkreis zur Anregung der Sende-bzw. Referenzspule und mit einer Auswerteeinheit und einem Logikkanal, die miteinander kommunizieren, wobei an der Sendespule und der Referenzspule jeweils ein Schalter zur Ansteuerung dieser Bauteile vorgesehen ist,
- Figur 1b: der elektrische Schaltkreis gemäß Figur 1a mit zwei der Referenzspule zugeordneten Schaltern,
- Figur 2: eine vergrößerte Darstellung der Sendespule und der Referenzspule, wobei die Referenzspule in einem Gehäuse gekapselt ist, und
- Figur 3: ein Frequenz-Zeit-Diagramm für die wechselweise Ansteuerung der Sendespule und der Referenzspule gemäß den Figuren 1a bzw. 1b.

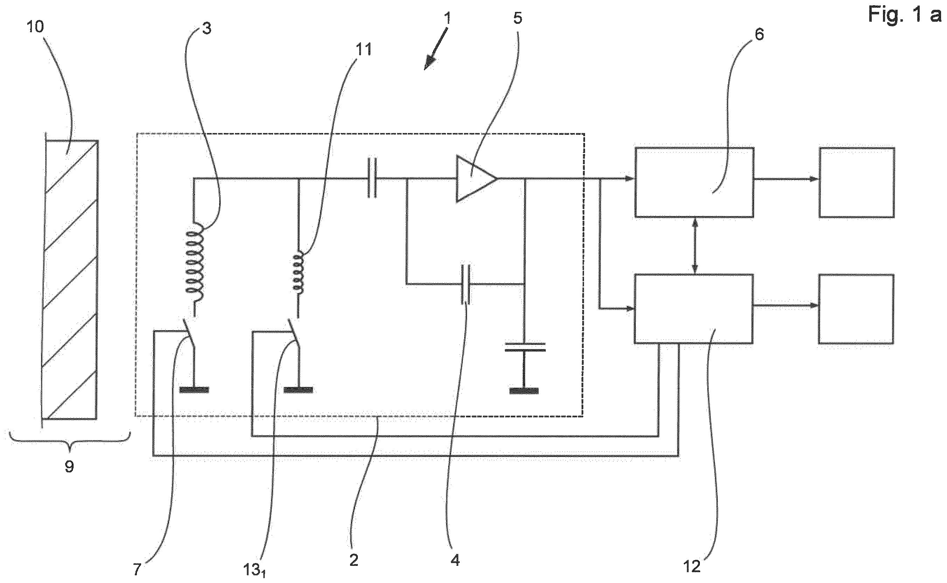

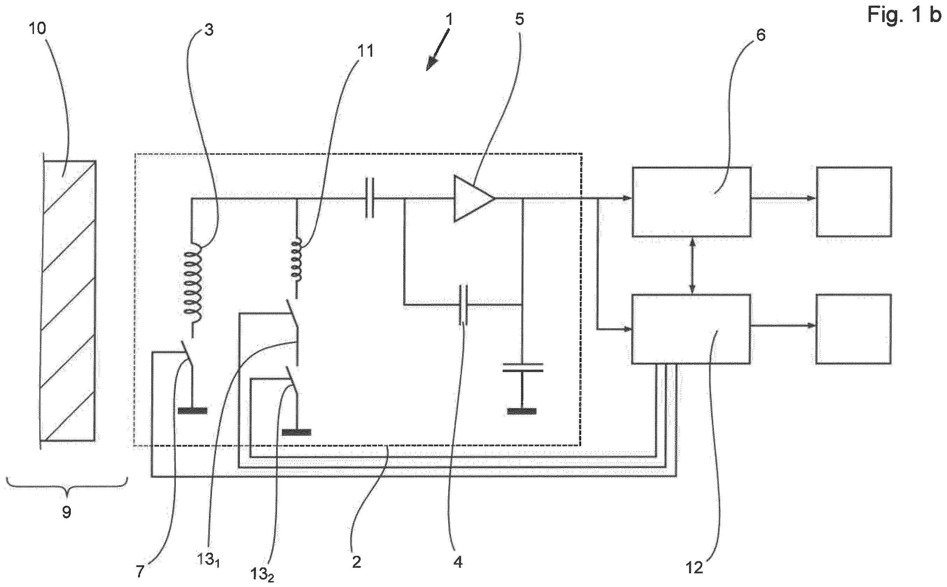

In den Figuren 1a und 1b ist ein elektrischer Schaltkreis 1 abgebildet, durch den ein induktiv betriebener Näherungsschalter gebildet ist. Der Näherungsschalter 1 besteht dabei aus einem Schwingkreis 2, in dem eine Sendespule 3, ein Kondensator 4 und ein Oszillator 5 geschaltet sind. Die Sendespule 3, der Kondensator 4 und der Oszillator 5 bilden einen sogenannten LC-Schwingkreis, durch den die Sendespule 3 angeregt ist.

Die Sendespule 3 ist dabei einem Überwachungsbereich 9 zugewandt, in den ein metallisches Objekt 10 eintaucht. Sobald das metallische Objekt 10 im Bereich der Sendespule 3 angeordnet ist, entzieht dieses der Sendespule 3 und somit dem Schwingkreis 2 Energie, wodurch sich die Frequenz des Schwingkreises 2 ändert. Der Sendespule 3 nachgeschaltet ist eine Auswerteeinheit 6, durch die eine solche Frequenzveränderung ΔF festgestellt und in ein elektrisches Schaltsignal umgewandelt ist.

Um nunmehr die Überprüfung der den elektrischen Schaltkreis 1 bildenden Bauteile, insbesondere des Kondensators 4 und des Oszillators 5 durchführen zu können, ist zwischen der Sendespule 3 und Masse ein Schalter 7 vorgesehen, der von dem Logikkanal 12 geöffnet oder geschlossen ist. Darüber hinaus ist parallel zu der Sendespule 3 eine Referenzspule 11 geschaltet, die über einen Schalter 13₁ mit Masse verbunden ist. Der Schalter 13₁ kann durch den Logikkanal 12 ein- bzw. ausgeschaltet werden.

Für den Betrieb des Näherungsschalter 1 und dessen permanenter Überprüfung auf Funktionsfähigkeit sind die Schalter 7 der Sendespule 3 und der Schalter 13₁ der Referenzspule 11 wechselweise geöffnet oder geschlossen. Zur Kalibrierung des Näherungsschalters 1 können beide Schalter 7 und 13₁ geschlossen sein.

Gemäß Figur 1b sind zwei oder mehrere Schalter 13₁, 13₂... 13ₙ in Reihe geschaltet, um zu gewährleisten, dass die Referenzspule 11 unbedingt von dem Schaltkreis 2 elektrisch getrennt ist. Wenn nämlich mehrere Schalter 13₁, 13₂ vorhanden sind und diese Schalter gleichzeitig geöffnet sind, dann ist die Referenzspule 11 von dem Schaltkreis 2 abgekoppelt, wenn einer der Schalter 13₁ oder 13₂ geöffnet ist. Sollte nämlich einer der Schalter 13₁ oder 13₂ defekt sein und eine Spannungstrennung nicht bewerkstelligen, dann ist die Referenzspule 11 immer noch mit dem Schaltkreis 1 elektrisch verbunden.

In der Auswerteeinheit 6 und dem Logikkanal 12 sind Datensätze hinterlegt und/oder einprogrammiert, die mit dem Schwingverhalten des Schaltkreises 2 in Beziehung stehen. Wenn nämlich die Sendespule 11 durch den geöffneten Schalter 7 von dem Schaltkreis 2 elektrisch entkoppelt ist und die Referenzspule 11 durch den geschlossenen Schalter 13₁ bzw. die beiden geschlossenen Schalter 13₁ und 13₂ an dem Schaltkreis 1 angeschlossen sind, dann schwingt zwar der Schwingkreis 2, jedoch bewirkt ein nicht erkanntes metallisches Objekt 10 keinerlei Energieentzug von der Referenzspule 11 und damit aus dem Schwingkreis 2. Durch das Schwingverhalten der Referenzspule 11 ist ausschließlich feststellbar, ob und inwieweit die elektrischen Komponenten des Schwingkreises 2 funktionsfähig und korrekt zusammengeschaltet sind. Ein Vergleich der ermittelten Messwerte mit den hinterlegten Ist-Werten in der Auswerteeinheit 6 bzw. dem Logikkanal 12 liefert demnach einen exakten Aufschluss darüber, dass der Näherungsschalter 1 funktionsfähig ist und folglich in einer sicherheitsrelevanten Anwendung weiterhin zuverlässig eingesetzt und verwendet werden kann.

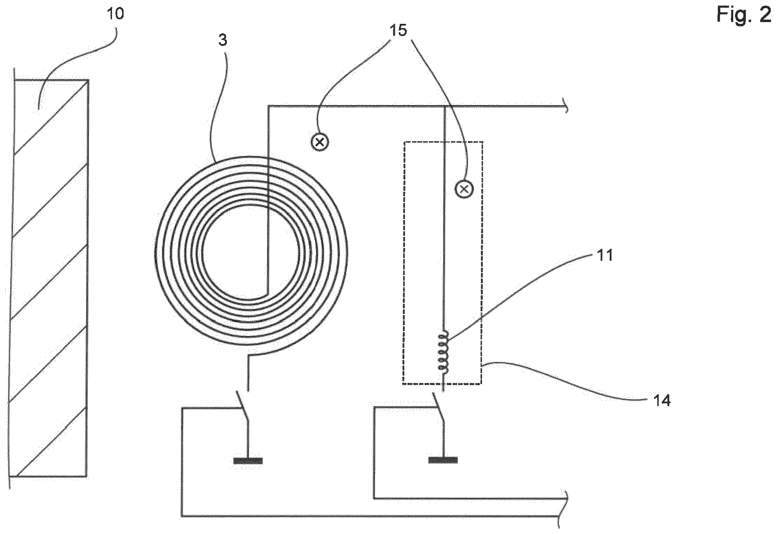

Um zu erreichen, dass ausschließlich durch die Sendespule 3 ein Energieentzug aus dem Schwingkreis 2 bei einem sich annähernden metallischen Objekt 10 in den Überwachungsbereich 9 stattfindet, ist die Sendespule 3 dem Überwachungsbereich 9 zugewandt und die Referenzspule 11 mit einem wesentlich größeren Abstand zu diesem angeordnet. Zudem ist die Referenzspule 11 gemäß Figur 2 in einem Gehäuse 14 gekapselt, sodass die Referenzspule 11 durch das sich annähernde Objekt 10 nicht in ihrem Schwingverhalten beeinflusst ist.

Ferner ist Figur 2 zu entnehmen, dass der Durchmesser der Wicklung der Sendespule 3 wesentlich größer bemessen ist als der Durchmesser der Referenzspule 11. In einer bevorzugten Ausgestaltung beträgt der Durchmesser der Wicklung der Sendespule 3 etwa 25 bis 30 mm und der Durchmesser der Referenzspule 11 etwa 1 bis 3 mm.

Die Sendespule 3 kann auch als Leiterspule bzw. Planarspule ausgeführt sein.

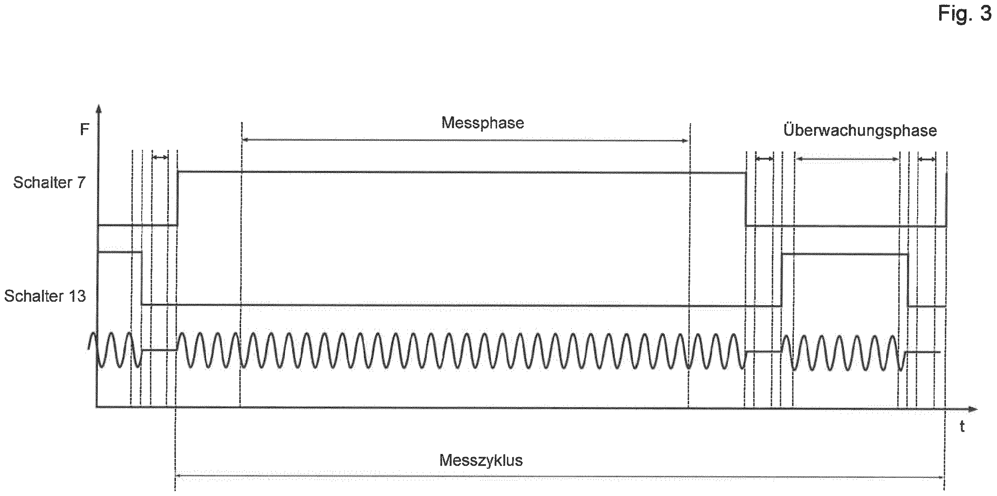

In Figur 3 ist das Schwingverhalten der Sendespule 3 und der Referenzspule 11 in einem Frequenz-Zeit-Diagramm dargestellt. Die Sendespule 3 schwingt dabei sinusförmig in einer vorgegebenen Frequenz und sobald der Schalter 7 geöffnet ist und folglich die Sendespule 3 von dem Schwingkreis 2 elektrisch entkoppelt ist, erzeugt diese keine Schwingung mehr im Schwingkreis 2. Gleichzeitig ist der Schalter 13₁ oder die beiden Schalter 13₁ und 13₂ geschlossen, sodass die Referenzspule 11 die Schwingung im Schwingkreis 2 bestimmt und während dieses Zeitfensters eine Überprüfung der in dem Schwingkreis 2 eingesetzten Bauteile durch die Auswerteeinheit 6 bzw. den Logikkanal 12 durchführbar ist. Die Auswerteeinheit 6 und der Logikkanal 12 kommunizieren dabei miteinander; dies ist schematisch dargestellt. Sollten die vorhandenen Messwerte mit den hinterlegten Ist-Werten übereinstimmen und keine Funktionsstörungen feststellbar sein, kann der Schalter 13₁ geöffnet und der Schalter 7 geschlossen sein, sodass der Näherungsschalter 1 in seine übliche induktive Betriebsweise überführt ist.

## Patentansprüche

1. Elektrischer Schaltkreis, durch den ein induktiv betriebener Näherungsschalter (1) gebildet ist, bestehend aus:
- einem Schwingkreis (2), in dem eine Sendespule (3), ein Kondensator (4) und ein die Sendespule (3) anregender Oszillator (5) parallel geschaltet sind,
- einer nachgeschalteten Auswerteeinheit (6), durch die die Amplitude (A) und die Frequenz (F) des Schwingkreises (2) erfassbar sind,
- einem der Sendespule (3) zugeordneten Überwachungsbereich (9), in den ein dort vorhandenes Objekt (10) dem Schwingkreis (2) Energie entzieht, wodurch in der Auswerteeinheit (6) eine Frequenz- (ΔF) und/oder Amplitudenveränderung (ΔA) des Schwingkreises (2) feststellbar und in ein Schaltsignal unwandelbar ist,
wobei dem Schwingkreis (2) eine Referenzspule (11) zugeordnet ist, die zu der Sendespule (3) und dem Oszillator (5) parallel geschaltet ist,
dass der Schwingkreis (2) einen Schalter (7) aufweist, der zwischen der Sendespule (3) und einem Nullpotenzial angeordnet ist, der in eine geöffnete und in eine geschlossene Schaltposition (Sₒ, S_{g}) durch einen Logikkanal (12) überführbar ist,
dass zwischen der Referenzspule (11) und dem Nullpotenzial mindestens ein Schalter (13₁, 13₂...) vorgesehen ist, der von dem Logikkanal (12) geschlossen oder geöffnet ist,
dass der Näherungsschalter zum Betrieb in einer sicherheitsrelevanten Anwendung ertüchtigt ist, wobei sowohl in der Auswerteeinheit (6) als auch in dem Logikkanal (12) der Referenzspule (11) Datensätze hinterlegt und/oder einprogrammierbar sind, durch die die Funktionsweise des Schwingkreises (2) anhand von vorgegebenen Frequenzen (F) und/oder Amplituden (A) überprüfbar sind, indem die Auswerteeinheit (6) und der Logikkanal (12) Messwerte zum Schwingverhalten des Schwingkreises (2) ermitteln und diese mit den hinterlegten Ist-Werten in der Auswerteeinheit (6) bzw. dem Logikkanal (12) vergleichen,
dass die Schalter (7, 13₁, 13₂...) der Sendespule (3) und der Referenzspule (11) wechselweise geöffnet bzw. geschlossen sind,
und dass die Auswerteeinheit (6) und der Logikkanal (12) während einer Überprüfungsphase, in welcher der Schalter (7), der die Sendespule (3) von Masse trennt geöffnet und der mindestens eine Schalter (13₁, 13₂...), der die Referenzspule (11) von Masse trennt, geschlossen ist, Datensätze in Form von Signalen und/oder Daten austauschen, die in der Auswerteeinheit (6) oder dem Logikkanal (12) miteinander verglichen sind, derart, dass aufgrund des Vergleichsergebnisses feststellbar ist, dass der Schwingkreis (2) korrekt funktioniert und dass im Falle einer Fehlerfeststellung der Näherungsschalter (1) ausgeschaltet ist.

2. Elektrischer Schaltkreis nach Anspruch 1,
**dadurch gekennzeichnet,**
**dass** die Schalter (7, 13₁, 13₂...) als Transistoren ausgestaltet sind und dass bei einer abwechselnden Schaltung der Transistoren (7, 13₁, 13₂...) der Sendespule (3) und der Referenzspule (11) gegen eine interne Referenz-Induktivität umgeschaltet ist und dass die Referenz-Induktivität mit dem Kondensator (4) des Schwingkreises (2) und dem Oszillator (5) eine Referenz-Messfrequenz erzeugen, die in der Auswerteeinheit (6) und/oder dem Logikkanal (12) auf Fehlerhaftigkeit überprüft ist.

3. Elektrischer Schaltkreis nach einem der vorgenannten Ansprüche,
**dadurch gekennzeichnet,**
**dass** die Sendespule (3) unmittelbar benachbart zu dem Überwachungsbereich (9) angeordnet ist und dass die Referenzspule (11) von dem Überwachungsbereich (9) derart beabstandet ist und/oder durch ein elektrisch leitfähiges Gehäuse (14) gekapselt ist, derart, dass ausschließlich das in dem Überwachungsbereich (9) vorhandene Objekt (10) das Schwingverhalten des Schwingkreises (2) mittels der elektrischen Kommunikation zwischen diesem und der Sendespule (3) beeinflusst.

4. Elektrischer Schaltkreis nach einem der vorgenannten Ansprüche,
**dadurch gekennzeichnet,**
**dass** die Wicklung der Sendespule (3) einen Durchmesser von 25 bis 30 mm und die Wicklung der Referenzspule (11) einen Durchmesser von 1 bis 2 mm aufweist.

5. Elektrischer Schaltkreis nach einem der vorgenannten Ansprüche,
**dadurch gekennzeichnet,**
**dass** die Sendespule (3) als Leiterplattenspule bzw. Planarspule ausgebildet ist.

6. Elektrischer Schaltkreis nach einem der vorgenannten Ansprüche,
**dadurch gekennzeichnet,**
**dass** der Sendespule (3) und der Referenzspule (11) ein Messsensor (15) zugeordnet ist, durch den die Temperatur im Bereich der Sendespule (3) und der Referenzspule (11) erfasst ist, und dass die ermittelten Temperaturwerte an die Auswerteeinheit (6) und den Logikkanal (12) zur Überwachung der vorherrschenden Temperatur und der damit verbundenen Frequenz- (ΔF) und/oder Amplitudenveränderung (ΔA) verwendet sind.

## Claims

1. Electrical circuit forming an inductively operated proximity switch (1), consisting of:
- a resonant circuit (2), in which a transmitting coil (3), a capacitor (4) and an oscillator (5) exciting the transmitting coil (3) are connected in parallel,
- a downstream evaluation unit (6), by means of which the amplitude (A) and the frequency (F) of the resonant circuit (2) can be detected,
- a monitoring region (9) associated with the transmitting coil (3), in which an object (10) which is present there draws energy from the resonant circuit (2), as a result of which a frequency (ΔF) and/or amplitude change (ΔA) of the resonant circuit (2) can be detected in the evaluation unit (6) and converted into a switching signal,
wherein
the resonant circuit (2) is associated with a reference coil (11) which is connected in parallel with the transmitting coil (3) and the oscillator (5),
in that the resonant circuit (2) has a switch (7) which is arranged between the transmitting coil (3) and a zero potential, and which can be transferred into an open and a closed switching position (S_{O}, S_{G}) by a logical channel (12),
in that between the reference coil (11) and the zero potential, at least one switch (13₁, 13₂...) is provided which is closed or opened by the logical channel (12),
in that the proximity switch is designed to operate in a safety-relevant application, wherein data sets are stored and/or programmable in both the evaluation unit (6) and the logical channel (12) of the reference coil (11), by means of which data sets the functioning of the resonant circuit (2) can be checked on the basis of predetermined frequencies (F) and/or amplitudes (A), by the evaluation unit (6) and the logical channel (12) determining measured values for the vibration behavior of the resonant circuit (2) and comparing these to the actual values stored in the evaluation unit (6) or the logical channel (12),
in that the switches (7, 13₁, 13₂...) of the transmitting coil (3) and the reference coil (11) are alternately opened or closed,
and in that during a checking phase, in which the switch (7) that disconnects the transmitting coil (3) from ground is opened and the at least one switch (13₁, 13₂...) that disconnects the reference coil (11) from ground is closed, the evaluation unit (6) and the logical channel (12) exchange data sets in the form of signals and/or data, which are compared to one another in the evaluation unit (6) or the logical channel (12), in such a way that, on the basis of the comparison result, it can be detected that the resonant circuit (2) is functioning correctly and that, in the event of a fault being detected, the proximity switch (1) is switched off.

2. Electrical circuit according to claim 1,
**characterized in that**
the switches (7, 13₁, 13₂...) are designed as transistors, and **in that** when the transistors (7, 13₁, 13₂...) of the transmitting coil (3) and the reference coil (11) are alternately switched, they are switched to an internal reference inductance, and **in that** the reference inductance together with the capacitor (4) of the resonant circuit (2) and the oscillator (5) generate a reference measuring frequency which is checked for faults in the evaluation unit (6) and/or the logical channel (12).

3. Electrical circuit according to either of the preceding claims,
**characterized in that**
the transmitting coil (3) is arranged immediately adjacent to the monitoring region (9), and **in that** the reference coil (11) is spaced apart from the monitoring region (9) and/or is encapsulated by an electrically conductive housing (14) in such a way that only the object (10) present in the monitoring region (9) influences the vibration behavior of the resonant circuit (2) by means of the electrical communication between said object and the transmitting coil (3).

4. Electrical circuit according to any of the preceding claims,
**characterized in that**
the winding of the transmitting coil (3) has a diameter of 25 to 30 mm, and the winding of the reference coil (11) has a diameter of 1 to 2 mm.

5. Electrical circuit according to any of the preceding claims,
**characterized in that**
the transmitting coil (3) is designed as a printed circuit board coil or a planar coil.

6. Electrical circuit according to any of the preceding claims,
**characterized in that**
the transmitting coil (3) and the reference coil (11) are assigned a measuring sensor (15), by means of which the temperature in the region of the transmitting coil (3) and the reference coil (11) is detected, and **in that** the determined temperature values are sent to the evaluation unit (6) and the logic channel (12) for monitoring the prevailing temperature and the associated frequency (ΔF) and/or amplitude change (ΔA).

## Revendications

1. Circuit électrique, au moyen duquel est formé un détecteur de proximité (1) fonctionnant par induction, constitué :
- d'un circuit oscillant (2) dans lequel une bobine émettrice (3), un condensateur (4) et un oscillateur (5) excitant la bobine émettrice (3) sont montés en parallèle,
- d'une unité d'évaluation (6) montée en aval, au moyen de laquelle l'amplitude (A) et la fréquence (F) du circuit oscillant (2) peuvent être détectées,
- d'une zone de surveillance (9) associée à la bobine émettrice (3), dans laquelle un objet (10) qui s'y trouve prélève de l'énergie du circuit oscillant (2), moyennant quoi une variation de fréquence (ΔF) et/ou d'amplitude (ΔA) du circuit oscillant (2) peut être constatée dans l'unité d'évaluation (6) et peut être convertie en un signal de commutation,
dans lequel
une bobine de référence (11) est associée au circuit oscillant (2), laquelle est montée en parallèle avec la bobine émettrice (3) et l'oscillateur (5),
que le circuit oscillant (2) présente un commutateur (7) qui est disposé entre la bobine émettrice (3) et un potentiel nul et qui peut être amené dans une position de commutation ouverte et dans une position de commutation fermée (Sₒ, S_{g}) par un canal logique (12),
qu'au moins un commutateur (13₁, 13₂...) est prévu entre la bobine de référence (11) et le potentiel zéro, lequel commutateur est fermé ou ouvert par le canal logique (12),
que le détecteur de proximité est apte à fonctionner pour une utilisation pertinente en termes de sécurité, dans lequel des jeux de données sont mémorisés et/ou programmables aussi bien dans l'unité d'évaluation (6) que dans le canal logique (12) de la bobine de référence (11), au moyen desquels jeux de données le fonctionnement du circuit oscillant (2) peut être vérifié à l'aide de fréquences (F) et/ou d'amplitudes (A) prédéfinies par le fait que l'unité d'évaluation (6) et le canal logique (12) déterminent des valeurs de mesure relatives au comportement oscillatoire du circuit oscillant (2) et les comparent avec les valeurs réelles mémorisées dans l'unité d'évaluation (6) ou dans le canal logique (12),
que les commutateurs (7, 13₁, 13₂...) de la bobine émettrice (3) et de la bobine de référence (11) sont alternativement ouverts ou fermés,
et que, pendant une phase de vérification dans laquelle le commutateur (7) qui sépare la bobine émettrice (3) de la masse est ouvert et l'au moins un commutateur (13₁, 13₂....) qui sépare la bobine de référence (11) de la masse est fermé, l'unité d'évaluation (6) et le canal logique (12) échangent des jeux de données sous forme de signaux et/ou de données qui sont comparés entre eux dans l'unité d'évaluation (6) ou dans le canal logique (12), de telle sorte qu'il peut être constaté, sur la base du résultat de la comparaison, que le circuit oscillant (2) fonctionne correctement et que, en cas de constatation d'une erreur, le détecteur de proximité (1) est mis hors tension.

2. Circuit électrique selon la revendication 1,
**caractérisé en ce**
**que** les commutateurs (7, 13₁, 13₂...) sont conçus comme des transistors et que, lors d'une commutation alternée des transistors (7, 13₁, 13₂...) de la bobine émettrice (3) et de la bobine de référence (11), on commute contre une inductance de référence interne et que l'inductance de référence génère, avec le condensateur (4) du circuit oscillant (2) et l'oscillateur (5), une fréquence de mesure de référence dont la défectuosité est vérifiée dans l'unité d'évaluation (6) et/ou le canal logique (12).

3. Circuit électrique selon l'une des revendications précédentes,
**caractérisé en ce**
**que** la bobine émettrice (3) est disposée directement à proximité de la zone de surveillance (9) et que la bobine de référence (11) est espacée de la zone de surveillance (9) et/ou est encapsulée par un boîtier (14) électriquement conducteur de telle sorte que seul l'objet (10) se trouvant dans la zone de surveillance (9) influence le comportement oscillatoire du circuit oscillant (2) au moyen de la communication électrique entre celui-ci et la bobine émettrice (3).

4. Circuit électrique selon l'une des revendications précédentes,
**caractérisé en ce**
**que** l'enroulement de la bobine émettrice (3) présente un diamètre allant de 25 à 30 mm et l'enroulement de la bobine de référence (11) présente un diamètre allant de 1 à 2 mm.

5. Circuit électrique selon l'une des revendications précédentes,
**caractérisé en ce**
**que** la bobine émettrice (3) est réalisée sous la forme d'une bobine de circuit imprimé ou d'une bobine planaire.

6. Circuit électrique selon l'une des revendications précédentes,
**caractérisé en ce**
**qu'**un capteur de mesure (15) est associé à la bobine émettrice (3) et à la bobine de référence (11), au moyen duquel la température est détectée dans la zone de la bobine émettrice (3) et de la bobine de référence (11), et que les valeurs de température déterminées sont utilisées au niveau de l'unité d'évaluation (6) et du canal logique (12) pour la surveillance de la température prédominante et de la variation de fréquence (ΔF) et/ou d'amplitude (ΔA) qui y est liée.
